# EUROPEAN PATENT APPLICATION

(11) **EP 4 814 520 A1**
(43) Date of publication of application: **30.09.2026**
(21) Application number: 26168235.5
(22) Date of filing: 26.03.2026
(51) Int. Cl.: G01R 33/34, G01R 33/3415

(54) **RECEIVE COIL DEVICE AND MAGNETIC RESONANCE IMAGING APPARATUS**

(30) Priority: 28.03.2025 JP 2025056488
(71) Applicant: FUJIFILM Corporation, Tokyo 106-8620 (JP)
(72) Inventor: OTAKE, Yosuke, Tokyo (JP); ARAI, Koichi, Tokyo (JP)
(74) Representative: Dehns Germany Partnerschaft mbB

(57) **Abstract**

A receive coil device (200) includes: receive coils (220) that are disposed in a lattice pattern in a bag-shaped planar cover (210), and that receive the nuclear magnetic resonance signal; a heat generating element (230) provided in each of the receive coils; heat insulating materials (240) that are disposed to sandwich each heat generating element, that reduce heat transfer from each heat generating element in a down direction toward a subject and heat transfer in an up direction, and that can dissipate heat from each heat generating element in a peripheral direction other than the down direction and the up direction; and a first air-permeable material that is laid in a space in the planar cover other than the heat generating element and the heat insulating materials, and that releases heat dissipated from the heat generating element in the peripheral direction and heat generated from the subject to an external space.

## Description

### BACKGROUND OF THE INVENTION

### 1. Field of the Invention

The present invention relates to a receive coil device and a magnetic resonance imaging apparatus, and particularly relates to a technique of reducing discomfort of a subject caused by heat generated by the receive coil device in a case where the receive coil device is disposed in close contact with the subject.

### 2. Description of the Related Art

In a magnetic resonance imaging (MRI) examination using an MRI apparatus, a radio frequency (RF) wave at a resonance frequency specific to an element is applied to an examination part of a subject, a generated nuclear magnetic resonance (NMR) signal is received by a receive coil device, and an image (MRI image) is generated by performing signal processing on the received NMR signal.

In recent years, a blanket-shaped receive coil device that can be disposed in close contact with an abdomen of a subject or from the abdomen to a chest of the subject has been proposed.

Since this type of receive coil device is in close contact with the subject, the receive coil device can efficiently receive a weak NMR signal generated from the subject.

In addition, since the blanket-shaped receive coil device has a lightweight and flexible structure as compared with an integrally molded rigid type, a structure is adopted in which a flexible cover that covers a component on an outer side of an internal electrical component is used. In addition, in order to avoid discomfort to a patient caused by the unevenness of an electric circuit and discomfort to the patient caused by the heat generated by an electric circuit of a coil, a relatively soft, foamed sheet with low thermal conductivity is placed.

As a result, the blanket-shaped receive coil device can be placed on the subject like a blanket, but heat generated from the subject is trapped on the subject side like a blanket, so that the subject feels hot and stuffy.

JP2005-102806A discloses an MRI coil in which a heat transfer prevention unit that prevents heat generated from an electronic component from being transferred to a surface material in contact with a subject is interposed between the surface material and an electronic component that generates a large amount of heat directly below the surface material.

JP2017-52917A discloses a receive coil comprising a flexible antenna portion and a reinforcing portion that reinforces the antenna portion, in which the receive coil has flexibility, and can maintain a coil shape during imaging and suppress movement of a subject during imaging.

### SUMMARY OF THE INVENTION

One embodiment according to the technology of the present disclosure provides a receive coil device and a magnetic resonance imaging apparatus that improve heat transfer characteristics and reduce the sensation of heat experienced by a subject.

A first aspect of the present invention relates to a receive coil device that is provided in a magnetic resonance imaging apparatus, and that receives a nuclear magnetic resonance signal from a subject, the receive coil device comprising: a plurality of receive coils that are disposed in a lattice pattern in a bag-shaped planar cover, and that receive the nuclear magnetic resonance signal; a heat generating element that is an electric circuit provided in each of the plurality of receive coils; heat insulating materials that are disposed in each region corresponding to the heat generating element, that are disposed to sandwich each heat generating element, that reduce heat transfer from each heat generating element in a down direction toward the subject and heat transfer in an up direction opposite to the down direction, and that are capable of dissipating heat from each heat generating element in a peripheral direction other than the down direction and the up direction; and a first air-permeable material that is laid in a space in the planar cover other than the heat generating element and the heat insulating materials, and that releases heat dissipated from the heat generating element in the peripheral direction and heat generated from the subject to an external space.

According to the first aspect of the present invention, by disposing the heat insulating materials that reduce heat transfer from the heat generating element in the down direction and the up direction and that are capable of dissipating heat from the heat generating element in the peripheral direction, the influence of heat applied to the subject inside the planar cover can be reduced, and heat on a front side of the planar cover corresponding to the heat generating element can be reduced. In addition, by the first air-permeable material laid in the space in the planar cover other than the heat generating element and the heat insulating materials, heat dissipated from the heat generating element in the peripheral direction and heat generated from the subject are released to the outside, and thus the discomfort of the subject due to heat can be reduced.

A second aspect of the present invention relates to the receive coil device according to the first aspect, in which the first air-permeable material preferably has a thickness that is a sum of a thickness of the heat generating element and thicknesses of the heat insulating materials that sandwich the heat generating element. As a result, the first air-permeable material is disposed in the space other than the heat generating element and the heat insulating materials, and the heat generated from the subject can be dissipated to the surface side of the planar cover through the first air-permeable material without being hindered by the heat insulating materials or the like, in addition to the heat dissipated from the heat generating element in the peripheral direction.

A third aspect of the present invention relates to the receive coil device according to the first or second aspect, in which an area of the first air-permeable material is preferably larger than an area of the heat insulating materials.

A fourth aspect of the present invention relates to the receive coil device according to any one of the first to third aspects, in which the first air-permeable material is preferably a shape memory material that is deformed or restored to an original shape in response to an external force. As a result, the first air-permeable material can repeat compression and expansion of air, activate the movement of heat, and accelerate heat dissipation by uniformizing heat.

A fifth aspect of the present invention relates to the receive coil device according to any one of the first to fourth aspects, further preferably comprising: a heat conductive layer on a surface of the heat insulating material in an up direction of the heat generating element or on an inner side of the planar cover corresponding to the heat insulating material in the up direction of the heat generating element.

The heat conductive layer is provided such that the air permeability of the first air-permeable material is not hindered, and can efficiently release heat accumulated in an upper portion of the planar cover.

A sixth aspect of the present invention relates to the receive coil device according to the fifth aspect, in which the heat conductive layer is preferably a heat dissipation sheet having a thermal conductivity of 1 W/(m·K) or more.

A seventh aspect of the present invention relates to the receive coil device according to any one of the first to sixth aspects, in which the planar cover is preferably made of a moisture-permeable waterproof material that is both waterproof and moisture-permeable.

An eighth aspect of the present invention relates to the receive coil device according to any one of the first to seventh aspects, further preferably comprising: a fixing belt that is disposed on an upper surface of the planar cover corresponding to a region in which the first air-permeable material is laid, and that fixes the subject lying on a bed to the bed. The fixing belt can also fix the receive coil device such that the receive coil device does not move relative to the subject.

A ninth aspect of the present invention relates to the receive coil device according to the eighth aspect, in which, in the fixing belt, a portion of the fixing belt is preferably fixed to the upper surface of the planar cover corresponding to the region in which the first air-permeable material is laid, or an indicator indicating a position through which the fixing belt passes is preferably added to the upper surface of the planar cover corresponding to the region in which the first air-permeable material is laid.

By disposing the fixing belt to correspond to the region in which the first air-permeable material is laid, the first air-permeable material is stretched and contracted between the subject and the fixing belt in response to the breathing motion of the subject, and the movement of heat is activated by repeating compression and expansion of air, and the heat dissipation is accelerated by uniformizing heat.

A tenth aspect of the present invention relates to the receive coil device according to any one of the first to ninth aspects, in which a second air-permeable material having a thickness thinner than a thickness of the first air-permeable material is preferably laid between an inner surface of the planar cover on a subject side and a surface of the heat insulating material on the subject side. The second air-permeable material is also stretched and contracted in response to the breathing motion of the subject, and the movement of heat accumulated between the heat insulating material on the subject side and the subject is activated, and the heat dissipation is accelerated by uniformizing heat.

An eleventh aspect of the present invention relates to the receive coil device according to any one of the first to tenth aspects, in which the planar cover preferably has an exhaust port on an outer periphery of the planar cover. The exhaust port makes it easier for the inside air in the planar cover to be released and for the outside air to be taken in.

A twelfth aspect of the present invention relates to the receive coil device according to the eleventh aspect, in which the exhaust port is preferably made of a material having higher air permeability than a lower surface of the planar cover on a subject side and an upper surface of the planar cover on a side opposite to the subject side, or is preferably subjected to processing for high air permeability.

A thirteenth aspect of the present invention relates to the receive coil device according to the eighth or ninth aspect, in which the receive coil device is preferably attached along at least an abdomen of the subject lying on the bed by the fixing belt.

A fourteenth aspect of the present invention relates to the receive coil device according to the thirteenth aspect, in which the first air-permeable material has a thickness that varies with up-down movement of the abdomen due to breathing of the subject, and has a function of accelerating heat transfer by repeatedly compressing and expanding air within the first air-permeable material.

A fifteenth aspect of the present invention relates to a magnetic resonance imaging apparatus comprising: the receive coil device according to any one of the first to fourteenth aspects.

According to the aspects of the present invention, the influence of heat applied to the subject from the heat generating element can be reduced, and heat dissipated in the peripheral direction of the heat generating element and the heat generated from the subject can be released to the outside, whereby the discomfort of the subject due to heat can be reduced.

### BRIEF DESCRIPTION OF THE DRAWINGS

FIG. 1 is a perspective view illustrating an appearance of a magnetic resonance imaging apparatus (MRI apparatus) to which a receive coil device according to an embodiment of the present invention is applied.
FIG. 2 is a diagram illustrating a schematic configuration of an internal portion of the MRI apparatus illustrated in FIG. 1.
FIG. 3 is a cross-sectional view illustrating a first embodiment of the receive coil device according to the embodiment of the present invention, and is a cross-sectional view along a plane parallel to a plane of the receive coil device.
FIG. 4 is a cross-sectional view of the receive coil device illustrated in FIG. 3 along a plane in a thickness direction.
FIG. 5 is a cross-sectional view illustrating a second embodiment of the receive coil device according to the embodiment of the present invention, and is a cross-sectional view along the plane in the thickness direction of the receive coil device.
FIG. 6 is a cross-sectional view illustrating a third embodiment of the receive coil device according to the embodiment of the present invention, and is a cross-sectional view along the plane in the thickness direction of the receive coil device.
FIG. 7 is a diagram illustrating a fourth embodiment of the receive coil device according to the embodiment of the present invention.
FIG. 8 is a cross-sectional view of the receive coil device illustrated in FIG. 7 during use.
FIG. 9 is a cross-sectional view illustrating a fifth embodiment of the receive coil device according to the embodiment of the present invention, and is particularly a cross-sectional view of the receive coil device during use.
FIG. 10 is a cross-sectional view illustrating a sixth embodiment of the receive coil device according to the embodiment of the present invention, and is particularly a cross-sectional view of the receive coil device during use.

### DESCRIPTION OF THE PREFERRED EMBODIMENTS

Hereinafter, preferred embodiments of a receive coil device and a magnetic resonance imaging apparatus according to embodiments of the present invention will be described with reference to the accompanying drawings.

### Appearance of MRI Apparatus

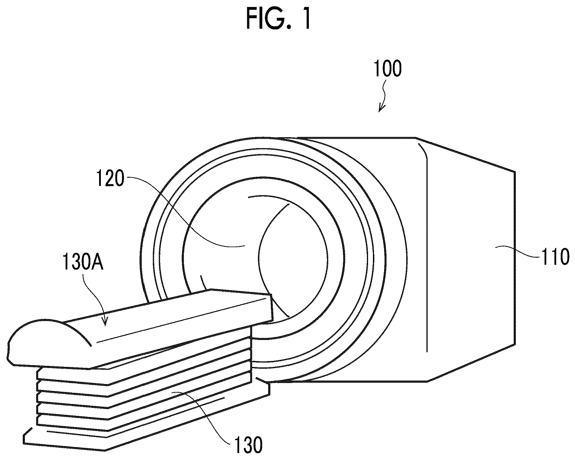

FIG. 1 is a perspective view illustrating an appearance of a magnetic resonance imaging apparatus (MRI apparatus) to which a receive coil device according to the embodiment of the present invention is applied.

An MRI apparatus 100 illustrated in FIG. 1 comprises a magnet 110 that generates a static magnetic field, and a bed 130 comprising a top plate 130A disposed on a front side of a cylindrical imaging space 120 provided in the magnet 110.

### Internal Configuration of MRI Apparatus

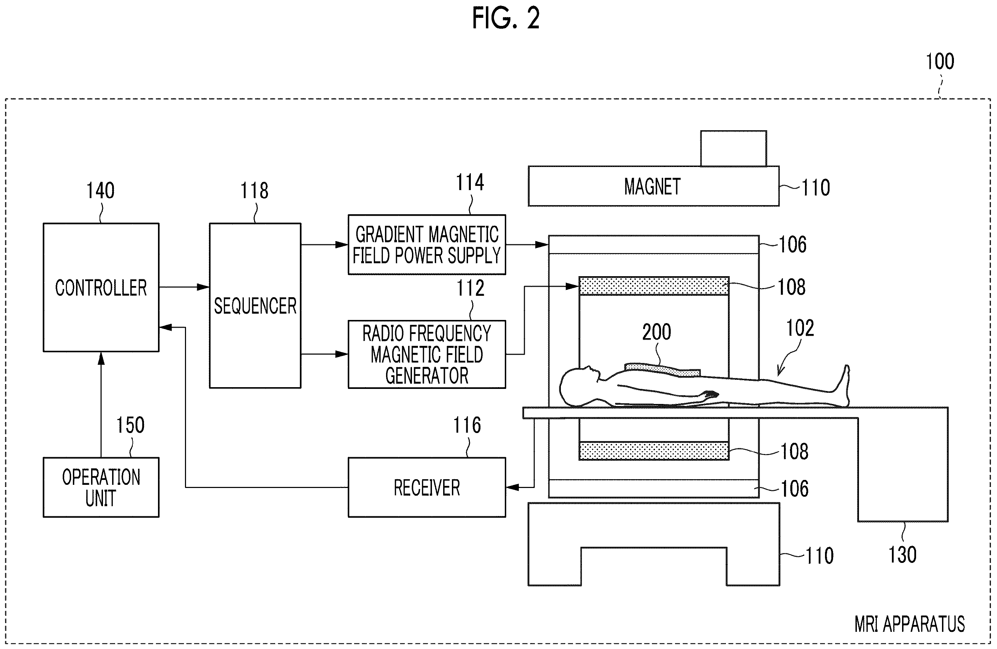

FIG. 2 is a diagram illustrating a schematic configuration of the internal portion of the MRI apparatus illustrated in FIG. 1.

As illustrated in FIG. 2, the MRI apparatus 100 comprises a magnet 110 that generates a uniform static magnetic field in the imaging space in which a subject 102 is disposed, a gradient magnetic field coil 106 that generates a gradient magnetic field in the imaging space, a radio frequency (RF) coil (transmit coil) 108 that generates a high-frequency magnetic field that generates a nuclear magnetic resonance signal (NMR signal) in an atomic nucleus of an atom constituting a tissue of the subject 102, and a receive coil device 200 comprising a receive coil that detects the NMR signal generated from the subject 102.

The receive coil device 200 is connected to the top plate 130A (FIG. 1) of the bed 130 by a cable that transmits the received NMR signal to a receiver 116. The subject 102 is usually disposed in the imaging space in a state of lying on the top plate 130A of the bed 130. The details of the receive coil device 200 will be described later.

The sequencer 118 transmits control information to the high-frequency magnetic field generator 112 and the gradient magnetic field power supply 114 in accordance with the imaging sequence, and acquires the NMR signal by the receiver 116.

The high-frequency magnetic field generator 112 generates high-frequency signals at the Larmor frequency that cause nuclear magnetic resonance based on the control information input from the sequencer 118, and transmits the radio frequency current pulse to the transmit coil 108. The RF pulse corresponding to the high-frequency signal is transmitted from the transmit coil 108 to the subject 102.

The receive coil device 200 detects the NMR signal generated by the excitation of the nuclear spins in the subject 102 by the RF pulse, and amplifies the detected NMR signal to transmit the amplified NMR signal to the controller 140. The NMR signal is usually generated by a gradient echo or spin echo, and an imaging sequence (pulse sequence). The generated signal is called an echo signal.

The gradient magnetic field coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space.

The sequencer 118 controls each unit to operate at timing and intensity programmed in advance. Among the programs, particularly, a program describing the timing and the intensity of the RF pulse, the gradient magnetic fields Gx, Gy, and Gz, and the signal reception is called an imaging sequence (pulse sequence).

Various pulse sequences depending on the purpose are known, but the detailed description thereof will be omitted here.

The controller 140 controls the operation of the MRI apparatus 100 via the sequencer 118 and receives the echo signal detected and the digital data (measurement data) obtained by the analog/digital conversion by the receiver 116, and performs various types of signal processing, such as image reconstruction.

The controller 140 receives various instruction inputs from an operation unit 150, collectively controls the respective units of the MRI apparatus 100, and performs processing of converting the measurement data in a spatial frequency domain received via the sequencer 118 into an image in the real space by performing inverse Fourier transformation, and the like to generate an MRI image.

The operation unit 150 includes a mouse, a keyboard, and the like and functions as a portion of a graphical user interface (GUI) that receives an input from an operator by using a display operation window of a display (not shown).

That is, the operation unit 150 and the display function as the GUI for the operator to start or stop (pause) the MRI apparatus 100, to select a pulse sequence, and to input imaging conditions, processing conditions, and the like.

### First Embodiment

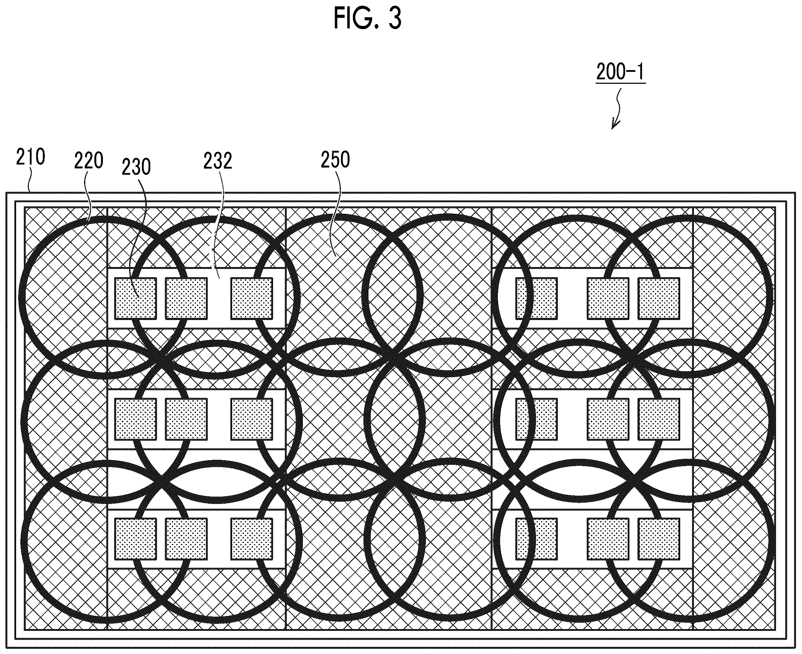

FIG. 3 is a cross-sectional view illustrating the first embodiment of the receive coil device according to the embodiment of the present invention, and is a cross-sectional view along the plane parallel to the plane of the receive coil device.

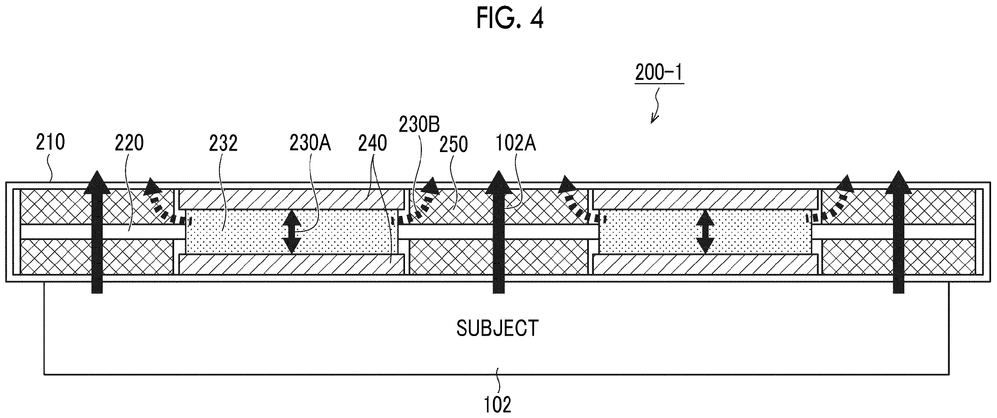

In addition, FIG. 4 is a cross-sectional view of the receive coil device illustrated in FIG. 3 along the plane in the thickness direction.

A receive coil device 200-1 according to the first embodiment illustrated in FIGS. 3 and 4 is, for example, a receive coil device for an abdomen that covers an abdomen of the subject 102 or an area of a chest from the abdomen, and has a blanket shape having flexibility.

In the receive coil device 200-1, a plurality of receive coils 220 that receive the nuclear magnetic resonance signal are disposed in a lattice pattern in a bag-shaped planar cover 210. In the present example, 18 receive coils 220 are disposed in a 3 × 6 arrangement (FIG. 3).

Further, a heat generating element group 232 that is an electric circuit is provided in each of the plurality of receive coils 220. In the present example, three heat generating elements 230 corresponding to three adjacent receive coils 220 are collected and disposed at one location to constitute one heat generating element group 232. Therefore, in the example illustrated in FIG. 3, 3 × 2 heat generating element groups 232 are disposed in a lattice pattern. In the present embodiment, the three heat generating elements 230 form a group, but the present invention is not limited to this. The number of heat generating elements 230 may be less than three or may be four or more.

In addition, the electric circuit provided in each receive coil 220 includes a preamplifier that amplifies the NMR signal received by the receive coil 220, a decoupling circuit that switches the receive coil 220 to a resonant state or a detuned state, and the like, and generates heat during operation.

In addition, as illustrated in FIG. 4, in the receive coil device 200-1, heat insulating materials 240 are disposed to sandwich the heat generating element group 232 for each region corresponding to each heat generating element group 232.

In FIG. 4, the heat insulating material 240 on the lower surface side of the heat generating element group 232 reduces heat transfer from the heat generating element group 232 in the down direction toward the subject 102, and the heat insulating material 240 on the upper surface side of the heat generating element group 232 reduces heat transfer from the heat generating element group 232 in the up direction (toward the upper surface side of the planar cover 210). An arrow 230A illustrated in FIG. 4 indicates a state where heat emitted from the heat generating element group 232 in the up-down direction is blocked by the heat insulating material 240.

In addition, the heat insulating material is not disposed around the heat generating element group 232 excluding the upper surface and the lower surface, and the heat emitted from the heat generating element group 232 is dissipated in a peripheral direction other than the down direction and the up direction. An arrow 230B illustrated in FIG. 4 indicates a state where the heat generated by the heat generating element group 232 is released from the periphery of the heat generating element group 232.

Further, as illustrated in FIGS. 3 and 4, in the receive coil device 200-1, an air-permeable material (first air-permeable material) 250 is laid in a space in the planar cover 210 other than the heat generating element group 232 and the heat insulating material 240.

An area of the laid air-permeable material 250 (an area projected onto the planar cover 210) is larger than an area of the heat insulating material 240 (see FIG. 3), whereby the heat in the planar cover 210 can be dispersed over a wide area while ensuring the flexibility of the receive coil device 200-1.

The air-permeable material 250 is a shape memory material that is deformed or restored to an original shape in response to an external force, and for example, an air fiber (registered trademark) can be applied.

Returning to FIG. 4, the air-permeable material 250 can release the heat dissipated from the heat generating element group 232 in the peripheral direction to the outside (the upper surface side of the planar cover 210) as indicated by the arrow 230B. In addition, the air-permeable material 250 can also release the heat generated from the subject 102 to the outside as indicated by an arrow 102A, and can further release moisture generated from the subject 102 to the outside.

As illustrated in FIG. 4, the air-permeable material 250 has a thickness that is a sum of a thickness of the heat generating element group 232 and thicknesses of two heat insulating materials 240 that sandwich the heat generating element group 232. That is, the thickness of the air-permeable material 250 matches (including substantially matches) a thickness that is a sum of the thickness of the heat generating element group 232 and the thicknesses of the two heat insulating materials 240, and in a state where an external force is not applied, the overall thickness of the receive coil device 200-1 is uniform.

With the receive coil device 200-1 according to the first embodiment, the heat transfer from the heat generating element group 232 in the down direction and the up direction is reduced by the heat insulating material 240, the influence of the heat applied to the subject 102 from the heat generating element group 232 can be reduced, and the heat of the front side of the planar cover 210 corresponding to the heat generating element group 232 can be reduced.

In addition, the heat dissipated in the peripheral direction of the heat generating element group 232 by the air-permeable material 250 can be favorably released to the outside through the air-permeable material 250, and at the same time, the heat and moisture generated from the subject can be released to the outside, whereby the discomfort of the subject due to the heat can be reduced.

### Second Embodiment

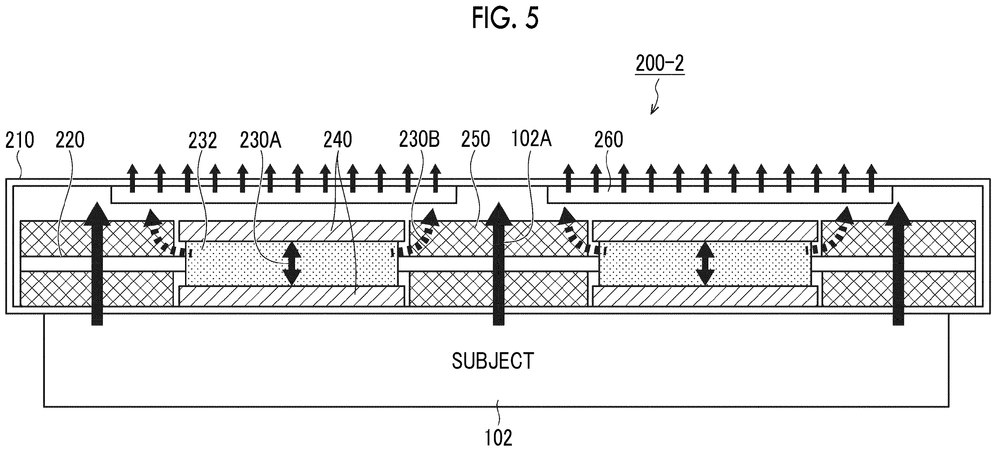

FIG. 5 is a cross-sectional view illustrating the second embodiment of the receive coil device according to the embodiment of the present invention, and is a cross-sectional view along the plane in the thickness direction of the receive coil device.

In a receive coil device 200-2 according to the second embodiment illustrated in FIG. 5, the same reference numerals are given to portions common to the receive coil device 200-1 according to the first embodiment illustrated in FIGS. 3 and 4, and the detailed description thereof will be omitted.

The receive coil device 200-2 according to the second embodiment illustrated in FIG. 5 is different from the receive coil device 200-1 according to the first embodiment in that the receive coil device 200-2 further comprises a heat conductive layer 260.

As illustrated in FIG. 5, the heat conductive layer 260 is disposed on a surface of the heat insulating material 240 in the up direction of the heat generating element group 232 or inside the planar cover 210 corresponding to the heat insulating material 240 in the up direction of the heat generating element group 232.

The heat conductive layer 260 is preferably a heat dissipation sheet having a thermal conductivity of 1 W/(m·K) or more.

In addition, it is preferable that the heat conductive layer 260 is disposed such that the entire or a part of the air-permeable material 250 is open in order to ensure moisture permeability.

With the receive coil device 200-2 according to the second embodiment, the heat accumulated in the upper portion of the planar cover 210 can be efficiently released by the heat conductive layer 260, whereby the temperature rise on the subject 102 side can be suppressed.

### Third Embodiment

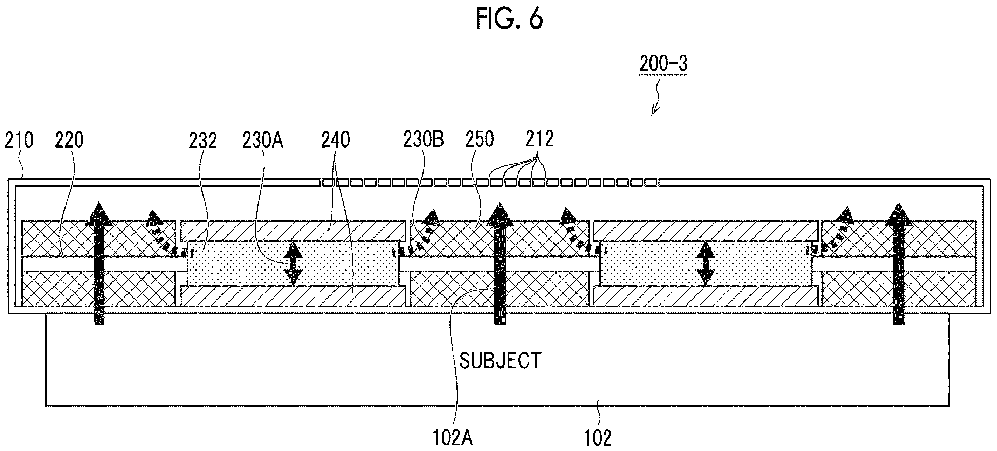

FIG. 6 is a cross-sectional view illustrating the third embodiment of the receive coil device according to the embodiment of the present invention, and is a cross-sectional view along the plane in the thickness direction of the receive coil device.

In a receive coil device 200-3 according to the third embodiment illustrated in FIG. 6, the same reference numerals are given to portions common to the receive coil device 200-1 according to the first embodiment illustrated in FIGS. 3 and 4, and the detailed description thereof will be omitted.

The receive coil device 200-3 according to the third embodiment illustrated in FIG. 6 is different from the receive coil device 200-1 according to the first embodiment in that the receive coil device 200-3 has a small-sized hole 212 in the entire or a part of the planar cover 210. The small-sized hole 212 has a size that is smaller than water particles in a liquid state and is larger than water particles in a gaseous state.

That is, it is preferable that the planar cover 210 of the receive coil device 200-3 is made of a moisture-permeable waterproof material that is both waterproof and moisture-permeable.

With the receive coil device 200-3 according to the third embodiment, moisture in the planar cover 210 can be efficiently discharged, and water droplets can be prevented from entering the planar cover 210 from the outside.

### Fourth Embodiment

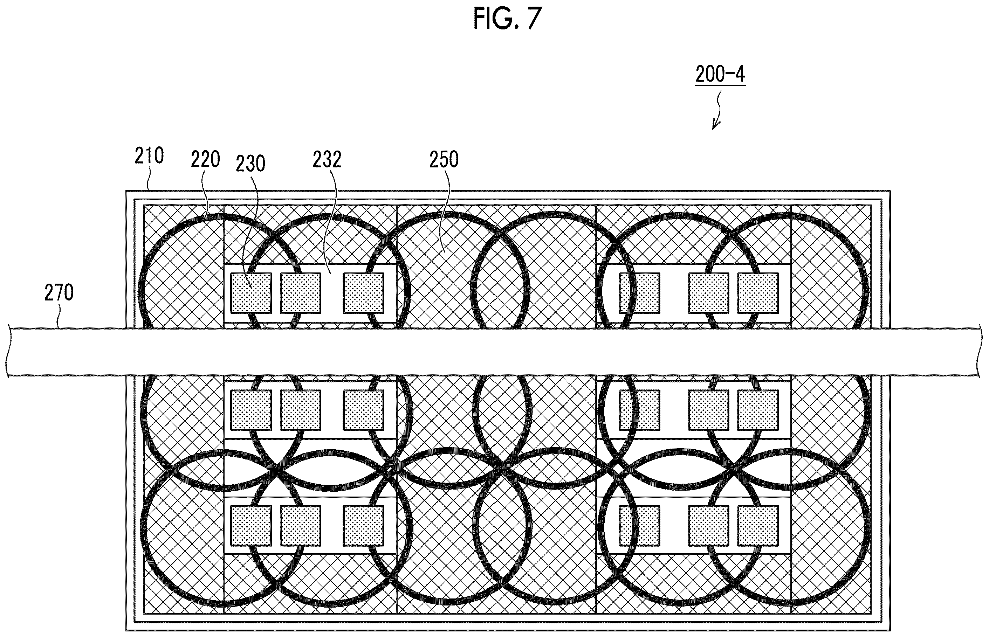

FIG. 7 is a diagram illustrating the fourth embodiment of the receive coil device according to the embodiment of the present invention.

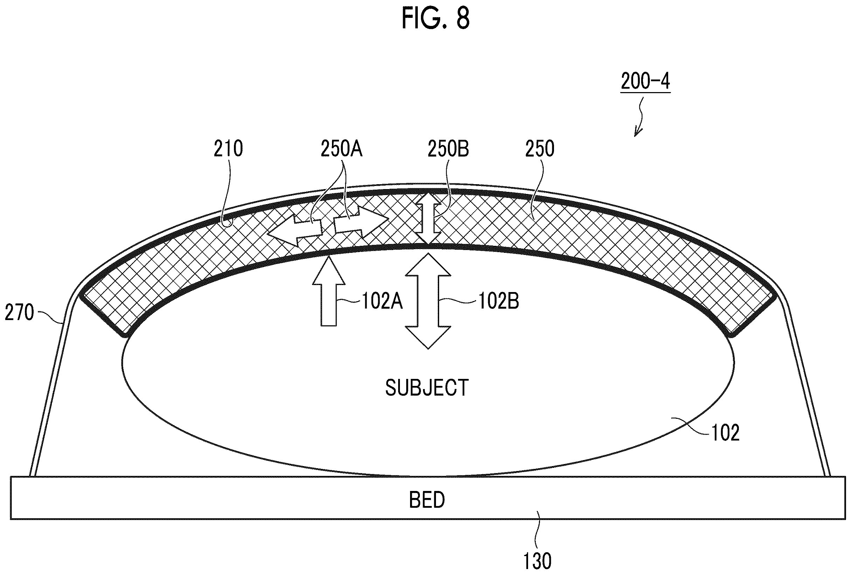

FIG. 8 is a cross-sectional view of the receive coil device illustrated in FIG. 7 during use.

As illustrated in FIG. 8, a receive coil device 200-4 comprises a fixing belt 270 that fixes the subject 102 on the bed 130 to the bed 130.

The receive coil device 200-4 is attached along at least an abdomen of the subject 102 on the bed 130 by the fixing belt 270. That is, the receive coil device 200-4 is attached to the subject 102 by being placed on the abdomen of the subject 102 on the bed 130 or covering the chest from the abdomen, and both ends of the fixing belt 270 are fixed to the bed 130.

In the fixing belt 270, a portion of the fixing belt 270 is disposed on the upper surface of the planar cover 210, corresponding to a region in which the air-permeable material 250 is laid.

As illustrated in FIG. 8, the heat generating element group 232 is disposed in a lattice pattern in the planar cover 210, but the fixing belt 270 is disposed at a position that does not overlap the heat generating element groups 232. For convenience, the receive coil 220 and the heat generating element group 232 are illustrated in FIG. 7, but it goes without saying that the receive coil 220 and the heat generating element group 232 cannot be visually recognized from the upper surface of the planar cover 210 on which the fixing belt 270 is disposed.

In addition, the fixing belt 270 is not limited to a case where a portion of the fixing belt 270 is attached to the planar cover 210, and the fixing belt 270 may be separated from the receive coil device 200-4. In this case, it is preferable to add an indicator indicating a position through which the fixing belt 270 passes (a position corresponding to a region in which the air-permeable material 250 is laid) to the upper surface of the planar cover 210 of the receive coil device 200-4.

In a usage state of the receive coil device 200-4 illustrated in FIG. 8, the air-permeable material 250 is present in a cross section of the receive coil device 200-4 including the fixing belt 270, and the heat generating element group 232 and the heat insulating material 240 are not present.

As illustrated in FIG. 8, in a case where the subject 102 breathes (diaphragmatic breathing) and the abdomen of the subject 102 moves up and down in a direction of the arrow 102B during the use of the receive coil device 200-4, the fixing belt 270 does not move, and the air-permeable material 250 is stretched and contracted in a direction of an arrow 250B between the abdomen moving up and down and the fixing belt 270. That is, the thickness of the air-permeable material 250 varies due to the up-down movement of the abdomen of the subject 102 due to the breathing of the subject 102.

In a case where the air-permeable material 250 is stretched and contracted, the compression and expansion of the air in the air-permeable material 250 are repeated, and the heat generated from the subject 102 as indicated by the arrow 102A enters the air-permeable material 250 and is diffused as indicated by the arrow 250A (the movement of the heat is activated). As a result, the heat is uniformized, the local heat concentration is alleviated, and the heat dissipation is further accelerated.

Although the heat generating element group 232 is not illustrated in FIG. 8, the heat released from the periphery of the heat generating element group 232 sandwiched by the heat insulating materials 240 as illustrated in FIG. 4 is also activated in movement of the heat by the stretching and contracting of the air-permeable material 250, and is efficiently released to the outside.

### Fifth Embodiment

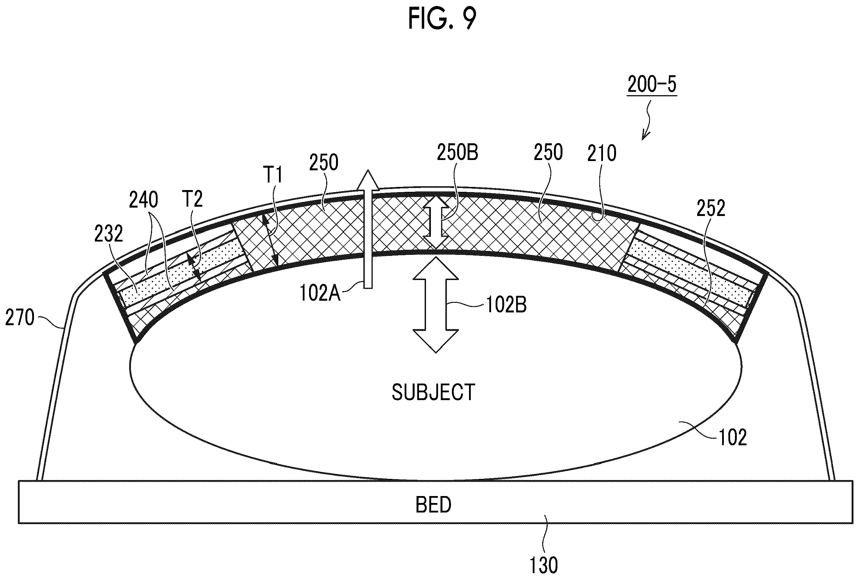

FIG. 9 is a cross-sectional view illustrating the fifth embodiment of the receive coil device according to the embodiment of the present invention, and is particularly a cross-sectional view of the receive coil device during use.

In a receive coil device 200-5 according to the fifth embodiment illustrated in FIG. 9, the same reference numerals are given to portions common to the receive coil device 200-4 according to the fourth embodiment illustrated in FIG. 8, and the detailed description thereof will be omitted.

The receive coil device 200-5 according to the fifth embodiment illustrated in FIG. 9 is different from the receive coil device 200-4 according to the fourth embodiment illustrated in FIG. 8 in that an air-permeable material (second air-permeable material) 252 having a thickness thinner than a thickness of the air-permeable material (first air-permeable material) 250 is further laid between an inner surface of the planar cover 210 on the subject 102 side and a surface of the heat insulating material 240 on the subject 102 side.

The air-permeable material 252 is also stretched and contracted in response to the breathing motion of the subject 102 together with the air-permeable material 250, and the movement of the heat accumulated between the heat insulating material 240 on the subject 102 side and the subject 102 is activated, and the heat dissipation is accelerated by uniformizing the heat.

As described above, the air-permeable material (air-permeable materials 250 and 252) can be disposed not only in a region in which the heat generating element group 232 and the like are not disposed but also in a region in which the heat generating element group 232 and the like are disposed.

A thickness T1 of the air-permeable material 250 is larger than a thickness T2 that is the sum of the thickness of the heat generating element group 232 and the thicknesses of the two heat insulating materials 240 that sandwich the heat generating element group 232 (T1 > T2), and a thickness of the added air-permeable material 252 preferably has a thickness that compensates for a difference (T1 - T2) between the thicknesses.

### Sixth Embodiment

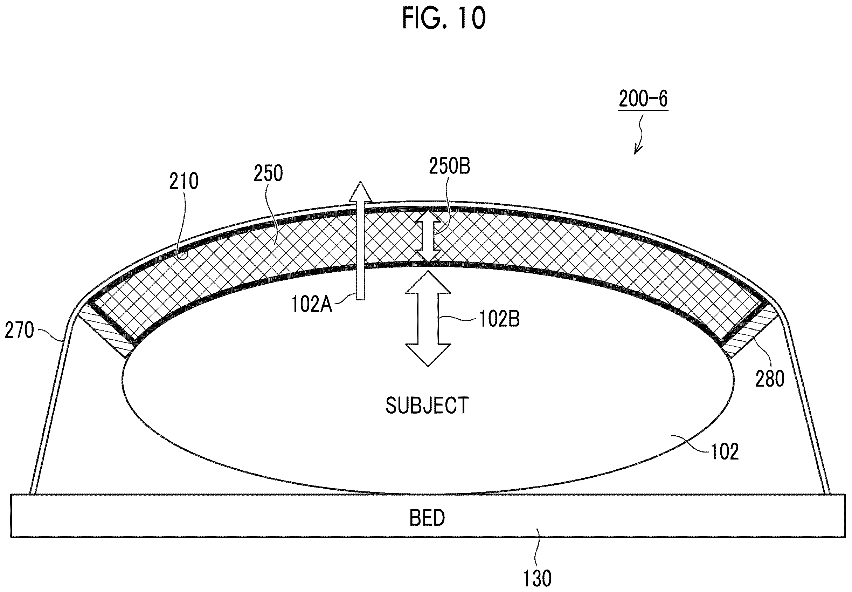

FIG. 10 is a cross-sectional view illustrating the sixth embodiment of the receive coil device according to the embodiment of the present invention, and is particularly a cross-sectional view of the receive coil device during use.

In a receive coil device 200-6 according to the sixth embodiment illustrated in FIG. 10, the same reference numerals are given to portions common to the receive coil device 200-4 according to the fourth embodiment illustrated in FIG. 8, and the detailed description thereof will be omitted.

The receive coil device 200-6 according to the sixth embodiment illustrated in FIG. 10 is different from the receive coil device 200-4 according to the fourth embodiment illustrated in FIG. 8 in that the receive coil device 200-6 has an exhaust port 280 on an outer periphery of the planar cover 210.

The exhaust port 280 can be made of a material having higher air permeability than a lower surface of the planar cover 210 on the subject 102 side and an upper surface of the planar cover 210 on a side opposite to the subject 102 side. As the material having high air permeability, a mesh material can be applied.

In addition, the exhaust port 280 may be subjected to processing for high air permeability. Examples of the processing for high air permeability include a non-crimped seam (stitching processing) and attachment of a zipper.

By providing the exhaust port 280 on the outer periphery of the planar cover 210 as described above, the inside air in the planar cover 210 is more easily released and the outside air is more easily taken in through the exhaust port 280.

### Others

In the present embodiment, the receive coil device for the abdomen used for the examination of the abdomen has been described, but the present invention may be used as a receive coil device for an examination of other parts of the subject other than the receive coil device for the abdomen.

Further, the present invention is not limited to the above embodiments, and can be subjected to various modifications without departing from the gist of the present invention.

### Explanation of References

100: MRI apparatus
102: subject
102A, 102B, 230A, 230B, 250A, 250B: arrow
106: gradient magnetic field coil
108: transmit coil
110: magnet
112: high-frequency magnetic field generator
114: gradient magnetic field power supply
116: receiver
118: sequencer
120: imaging space
130: bed
130A: top plate
140: controller
150: operation unit
200, 200-1 to 200-6: receive coil device
210: planar cover
212: hole
220: receive coil
230: heat generating element
232: heat generating element group
240: heat insulating material
250, 252: air-permeable material
260: heat conductive layer
270: fixing belt
280: exhaust port
Gx, Gy, Gz: gradient magnetic field
T1, T2: thickness

## Claims

1. A receive coil device (200) that is provided in a magnetic resonance imaging apparatus (100), and that receives a nuclear magnetic resonance signal from a subject (102), the receive coil device comprising:
a plurality of receive coils (220) that are disposed in a lattice pattern in a bag-shaped planar cover (210), and that receive the nuclear magnetic resonance signal;
a heat generating element (230) that is an electric circuit provided in each of the plurality of receive coils;
heat insulating materials (240) that are disposed in each region corresponding to the heat generating element, that are disposed to sandwich each heat generating element, that reduce heat transfer from each heat generating element in a down direction toward the subject and heat transfer in an up direction opposite to the down direction, and that are capable of dissipating heat from each heat generating element in a peripheral direction other than the down direction and the up direction; and
a first air-permeable material (250) that is laid in a space in the planar cover other than the heat generating element and the heat insulating materials, and that releases heat dissipated from the heat generating element in the peripheral direction and heat generated from the subject to an external space.

2. The receive coil device according to claim 1,
wherein the first air-permeable material has a thickness that is a sum of a thickness of the heat generating element and thicknesses of the heat insulating materials that sandwich the heat generating element.

3. The receive coil device according to claim 1 or 2,
wherein an area of the first air-permeable material is larger than an area of the heat insulating materials.

4. The receive coil device according to any one of claims 1 to 3,
wherein the first air-permeable material is a shape memory material that is deformed or restored to an original shape in response to an external force.

5. The receive coil device according to any one of claims 1 to 4, further comprising:
a heat conductive layer (260) on a surface of the heat insulating material in an up direction of the heat generating element or on an inner side of the planar cover corresponding to the heat insulating material in the up direction of the heat generating element.

6. The receive coil device according to claim 5,
wherein the heat conductive layer is a heat dissipation sheet having a thermal conductivity of 1 W/(m·K) or more.

7. The receive coil device according to any one of claims 1 to 6,
wherein the planar cover (210) is made of a moisture-permeable waterproof material that is both waterproof and moisture-permeable.

8. The receive coil device according to any one of claims 1 to 7, further comprising:
a fixing belt (270) that is disposed on an upper surface of the planar cover corresponding to a region in which the first air-permeable material is laid, and that fixes the subject lying on a bed to the bed.

9. The receive coil device according to claim 8,
wherein, in the fixing belt (270), a portion of the fixing belt is fixed to the upper surface of the planar cover corresponding to the region in which the first air-permeable material is laid, or an indicator indicating a position through which the fixing belt passes is added to the upper surface of the planar cover corresponding to the region in which the first air-permeable material is laid.

10. The receive coil device according to any one of claims 1 to 9,
wherein a second air-permeable material having a thickness thinner than a thickness of the first air-permeable material is laid between an inner surface of the planar cover on a subject side and a surface of the heat insulating material on the subject side.

11. The receive coil device according to any one of claims 1 to 10,
wherein the planar cover (210) has an exhaust port (280) on an outer periphery of the planar cover.

12. The receive coil device according to claim 11,
wherein the exhaust port (280) is made of a material having higher air permeability than a lower surface of the planar cover on a subject side and an upper surface of the planar cover on a side opposite to the subject side, or is subjected to processing for high air permeability.

13. The receive coil device according to claim 8 or 9,
wherein the fixing belt (270) is attached along at least an abdomen of the subject lying on the bed.

14. The receive coil device according to claim 13,
wherein the first air-permeable material has a thickness that varies with up-down movement of the abdomen due to breathing of the subject, and has a function of accelerating heat transfer by repeatedly compressing and expanding air within the first air-permeable material.

15. A magnetic resonance imaging apparatus comprising:
the receive coil device according to any one of claims 1 to 14.
